Europäisches Patentamt

European Patent Office

Office européen des brevets

(11) Publication number: 0 499 855 A2

# EUROPEAN PATENT APPLICATION

(21) Application number: 92101538.4

(22) Date of filing: 30.01.92

(51) Int. Cl.5: H01L 21/285, H01L 21/3205, H01L 23/485

(30) Priority: 21.02.91 US 659593

(43) Date of publication of application:
26.08.92 Bulletin 92/35

(84) Designated Contracting States:
DE FR GB IT NL

(71) Applicant: TEXAS INSTRUMENTS
INCORPORATED
13500 North Central Expressway
Dallas Texas 75265(US)

(72) Inventor: Rodder, Mark S.
3212 Westminster Avenue
Dallas, Texas 75205(US)

(74) Representative: Schwepfinger, Karl-Heinz,
Dipl.-Ing. et al
Prinz, Leiser, Bunke & Partner Manzingerweg
7
W-8000 München 60(DE)

(54) Method and structure for microelectronic device incorporating low-resistivity straps between conductive regions.

(57) A microelectronic device (10) provides decreased contact and sheet resistivity for strap (24) and decreased contact resistivity with respect to gate (14) and/or moat (16). The inventive method allows strap (24) to overpass unrelated gate (20) if desired. In accordance with the invention, unrelated conductor (20) can be electrically isolated from overlying strap (24) by virtue of insulating (22). Further, strap (24) is formed to include titanium silicide layer (130) and noncrystalline silicon sublayer (132). Additionally, the strap formation process allows the patterning and removal of the silicide-forming metal, such as titanium, prior to the intended reaction of such metal with noncrystalline silicon to form a silicide, thereby avoiding the potential creation of undesired titanium oxide compounds which may generate undesirable shorting effects.

Fig. 2f

## BACKGROUND OF THE INVENTION

### 1. Field of the Invention

This invention relates to microelectronic devices incorporating straps. More particularly, it is concerned with the method and structure for forming such a device incorporating low-resistivity straps between conductive regions.

### 2. Description of the Prior Art

The growing use of silicides (e. g. titanium silicide) in microelectronic devices is well known. Silicides, among other uses, are used to diminish contact resistivity for conductor sites such as at moats and gates. Silicides are also used for the formation of local interconnects or straps to reduce sheet resistivity in the interconnect. One method of using silicides simultaneously for these types of applications is to lay down a blanket of titanium (or other silicide-forming metal) followed by a blanket of less conductive material, for example noncrystalline silicon. The noncrystalline silicon is then patterned so that it remains only where the straps are to be formed. Then the titanium is reacted with the overlying noncrystalline silicon to form titanium silicide. Titanium also reacts with underlying polysilicon and silicon at various sites, not only where local interconnects are formed but at other sites.

One problem with this technique of forming straps and silicided moats and gates simultaneously is that such a method constrains the initial titanium deposition to be a certain minimum thickness in order to achieve acceptable silicide sheet resistivity at moats, gates, and any other site where the silicide is to be formed.

Another problem is that since titanium is blanket deposited for simultaneous creation of contacts and straps, one area of the device cannot be silicide-connected to another if an unrelated, exposed conductor is interposed. That is to say, such an interconnect would be shorted to the interposing unrelated conductor.

Another problem is that the patterned etch of the overlying noncrystalline silicon must substantially stop on the underlying titanium to maintain a desired titanium thickness over moat and gate regions after etch. However, the selectivity of the silicon etch to underlying titanium is not large such that substantial loss of titanium can result during the silicon etch. Additionally, for thin titanium, the silicon etch might etch through the underlying titanium and even etch into the underlying silicon moat regions.

Yet another problem with this technique is that titanium necessarily reacts with underlying materials such as oxide in locations without overlying noncrystalline silicon. This reaction with other materials such as oxygen or nitride could lead to the formation of compounds not as easily removed -- for example titanium oxide or titanium oxide nitride (Ti-O-N). Filaments of such undesirably formed compounds as titanium oxide nitride may not be easily removed and can often lead to undesirable shorting.

What is needed then is a method which allows for formation of silicided interconnects yet also allows the silicided interconnect to be as thin as necessary, that allows the interconnects to practically overlie unrelated conductors. Also needed is a method wherein titanium will not be reacted in such a manner as to form undesirable compounds which cannot be removed or lead to shorting. Also needed is a method whereby the interconnect can be patterned and etched with high selectivity to underlying layers. Additionally, a method is needed for which a silicided interconnect can be formed independently of gate and moat silicidation.

## SUMMARY OF THE INVENTION

The problems outlined above are in large measure solved by the microelectronic device in accordance with the present invention. That is to say, the device hereof provides a distinct silicide formation for purposes of forming a silicided local interconnect, allows interconnects to effectively overpass unrelated conductors, provides a method to obviate undesirable nonsilicon titanium reactions during strap formation, and provides a method to etch the interconnect with high selectivity to underlying layers.

The microelectronic device in accordance with the present invention provides a substrate having a first conductive area and a second conductive area. An insulating layer is selectively formed over the substrate so as not to cover predetermined portions of the first and second conductive areas. A conducting strap connects the first and second conductive areas. The conducting strap or local interconnect includes a reacted sublayer, (preferably a silicide). The fact that the strap is silicided lowers the contact resistivity between the strap and the first and second conductive areas, respectively, and also lowers the sheet resistivity of the strap itself.

In preferred embodiments a silicide-forming metal is reacted with silicon to form the silicide sublayer, while the overlying silicon sublayer substantially includes noncrystalline silicon. The insulating layer in preferred embodiments substantially includes oxide.

In accordance with the present invention, the formation of titanium specifically for the interconnect allows for a silicided interconnect unconstrained by simultaneous formation of silicided gates and moats as in prior art. Furthermore, the insulating layer allows the local interconnect to be formed so as to overpass unrelated conductors without shorting thereto. Also, titanium can be patterned prior to the silicide-producing reaction in order to avoid the deleterious by-products described above, if necessary. Also, titanium can be etched with high selectivity to the underlying insulating layer and thus the interconnect can be etched without need for a silicon etch to stop substantially on underlying titanium.

## BRIEF DESCRIPTION OF TIE DRAWINGS

Figs. 1A-1D, in partial cross section, illustrate progressive formation of a microelectronic device formed in accordance with the prior art.

Figs. 2A-2F, in partial cross section, illustrate progressive steps in the formation of a microelectronic device in accordance with the present invention; and

Fig. 3 schematically illustrates a 6T SRAM cell and associated circuitry incorporated in the preferred microelectronic device.

## DESCRIPTION OF THE PREFERRED EMBODIMENTS

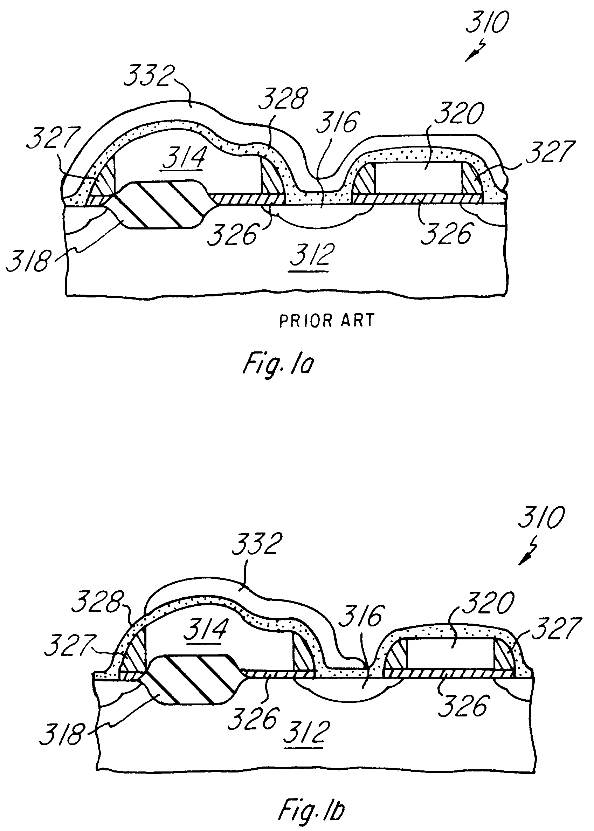

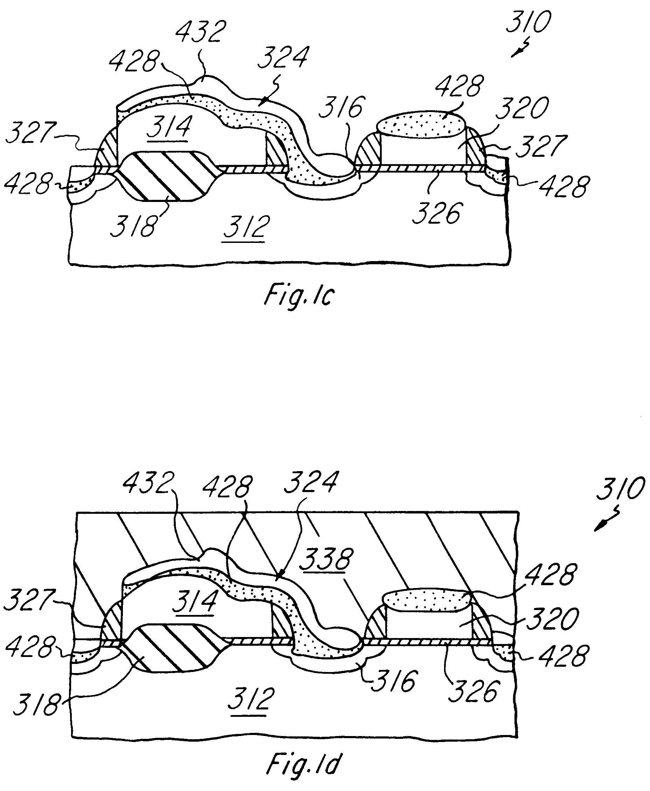

Referring now to the drawings in general and Fig. 1A in particular, the method of manufacturing device 310 of the prior art will now be described. Substrate 312 is typically formed of a monocrystalline silicon wafer. Substrate 312 is formed so as to include a field oxide 318. Substrate 312 further includes a gate oxide 326, a doped moat 316, a doped gate 314, doped, unrelated gate 320 and sidewall oxides 327. A silicide-forming metal layer 328, for example titanium, is formed and then a noncrystalline silicon layer 332 is formed thereover as shown.

Referring to Fig. 1B, noncrystalline silicon layer 332 is then patterned and etched as shown with the etch of layer 332 substantially needing to stop on layer 328. Noncrystalline silicon layer 332 may be undoped or is appropriately doped for the application -- either p-type or n-type in a manner well known in the art.

Titanium layer 328 is reacted with overlying noncrystalline silicon layer 332 and underlying silicon and polysilicon to form titanium silicide sublayer 428 as shown in Fig. 1C. The structure resulting from the reaction includes strap 324 having a sublayer 432 of unconsumed noncrystalline silicon and silicide sublayer 428. Note the formation of silicide 428 at other areas such as at the top of unrelated gate 428. It should also be noted that although titanium layer 328 is graphically depicted in a substantially similar manner as titanium silicide sublayer 428 the two are chemically and electrically different.

Referring to Fig. 1D, overlying insulator 338 is then formed over the resulting structure to complete microelectronic device 310. It should be noted that other aspects of device have not been shown which would require other steps well understood in the art such as formation of bonding pads, etc.

The disadvantage of the prior art device 310 will be noticed in Fig. 1B in that only noncrystalline silicon layer 332 is patterned but titanium layer 328 cannot be completely patterned. In other words the titanium must be left at sites for formation of silicide such as at unrelated gate 320. Thus in Fig. 1C it will be noted that the titanium is reacted to simultaneously silicide moat 316 and gate regions 314, 320 as well as to form strap 324 between gate 314 and moat 316.

As mentioned above, another disadvantage is the low etch selectivity between titanium and silicon. Hence, the etch required to arrive at the structure may result in damage underlying the exposed portions of titanium layer 328.

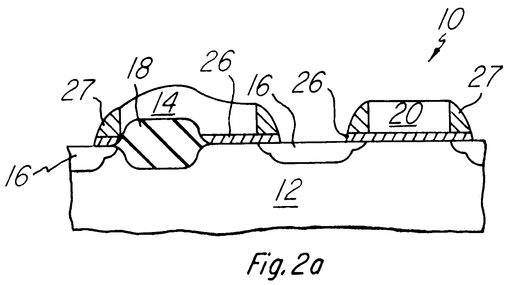

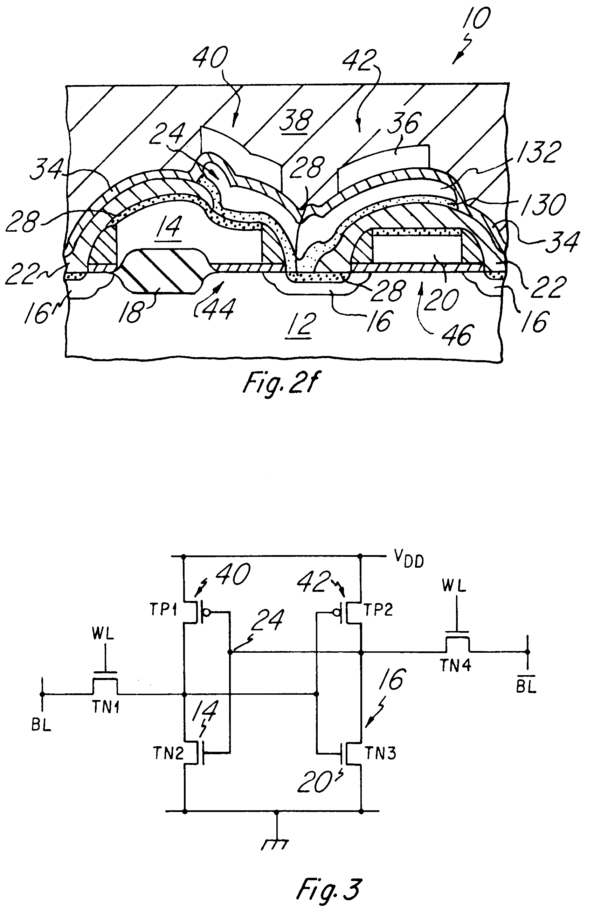

Referring now to the present invention and Fig. 2F in particular, a microelectronic device 10, incorporating low-resistivity straps between conductive regions, in accordance with the invention, is partially depicted. Device 10 includes a substrate 12 having a gate or first region 14, a moat or second region 16, a field oxide 18, and an unrelated gate 20. Device 10 further includes insulating layer or oxide 22, and a local interconnect or strap 24. Strap 24 electrically connects gate 14 to moat 16 but is not in electrical communication with unrelated gate 20. Within the inventive concept, a strap is a conductor which places two or more conductive elements in electrical communication. Thus a strap can be a local interconnect but may also be any other connective conductor. Although device 10 is an SRAM, the inventive strap could be used in any application requiring such a strap, such as in, by way of example but not limited to, an SRAM, DRAM, logic or SOI circuit.

In accordance with the present invention, strap 24 provides low contact resistance to gate 14 and moat 16 respectively as well as providing low sheet resistance therebetween. Oxide 22 is formed so as to allow strap 24 to overlie unrelated gate 20 without shorting thereto - indeed strap 24 can be connected with other conductors at other portions of device 10 if desired in accordance with the invention. Further, device 10 is constructed so that strap 24 can be formed in such a fashion that formation of undesirable compounds are avoided as discussed above.

Referring now to Fig. 2A, the method of forming device 10 will now be described. Substrate 12 is preferably substantially formed of a monocrystalline-silicon wafer although it will readily be understood that other semiconducting materials (for example gallium arsenide or germanium) could also be used. Substrate 12 is formed so as to include field oxide 18, such formation being well known in the art. Substrate 12 further includes gate oxide 26, doped moat 16, doped gate 14, doped, unrelated gate 20 and sidewall oxides 27. The formation of the elements as depicted in Fig. 2A is well known to those skilled in the art and thus will not be described in greater detail. It should be noted that geometric configurations and proportions are not drawn to scale and should not be interpreted in any of the figures as limiting the scope of the invention.

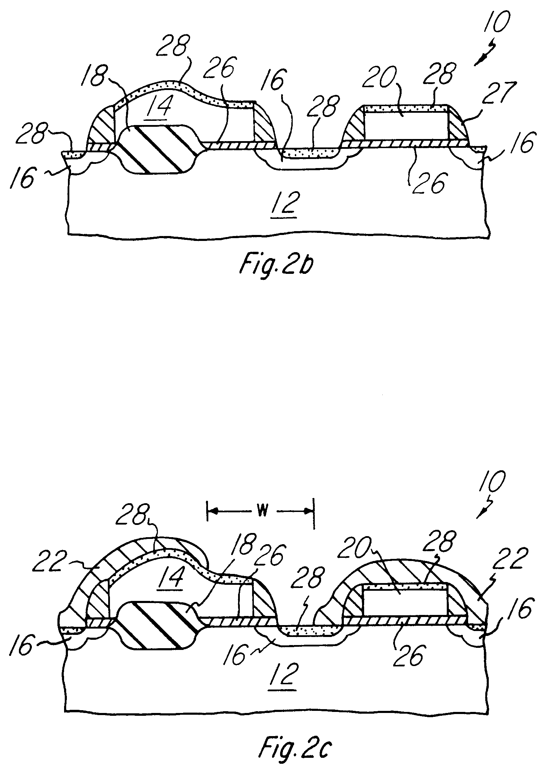

Referring to Fig. 2B, a silicide-forming metal, for example titanium, is blanket deposited. The titanium is then reacted with the underlying silicon regions (and selected titanium is removed) to form a self-aligned titanium silicide 28 as shown. It should be further noted that any other silicide-forming metal could be used as suited to a given application, such applications being well understood in the art. Typically, a silicide may be formed by reaction of titanium and silicon at 700°C for 30 minutes in a nitrogen ambient.

Referring to Fig. 2C, insulator layer 22 is formed and patterned to expose a contact window designated W as shown. Insulating layer 22 can be any of a number of combinations of insulating material well known in the art. In the preferred embodiment the insulating material is oxide.

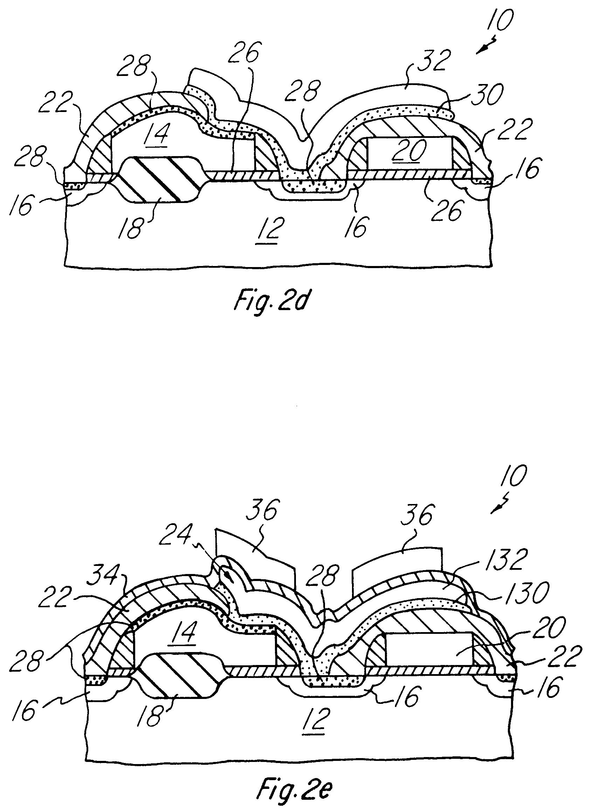

Referring to Fig. 2D, a layer of conductive, substrate-reactive material 30 is formed. In the preferred embodiment, substrate-reactive material 30 is titanium. However, materials other than titanium which are reactive with a given underlying substrate could also be used. In the preferred embodiment, the reacted material (discussed below) is a silicide but the invention is not limited to this.

Then a layer of semiconductor material 32, such as noncrystalline silicon, is formed. In the preferred embodiment, the semiconductor material 32 is a noncrystalline silicon layer, however a semiconductor material other than silicon could be used, and indeed if a nonsilicon substrate were used, a nonsilicon semiconductor might be more appropriate. Silicon layer 32 is formed to a thickness in a range of about 500-2,500 angstroms. Titanium layer 30 and noncrystalline silicon layer 32 are then patterned and etched to define the structure shown in Fig. 2D. Noncrystalline silicon layer 32 may be undoped or appropriately doped for the application, either p-type or n-type in a manner well known in the art.

Referring to Fig. 2E, second titanium layer 30 is reacted with noncrystalline silicon layer 32 to form strap 24 which includes a reacted sublayer or titanium silicide layer 130 and noncrystalline silicon sublayer 132. In the course of the reaction a certain proportion of the noncrystalline silicon from noncrystalline silicon layer 32 is consumed and thus it will be understood that the original noncrystalline layer 32 has a greater thickness than the resulting noncrystalline sublayer 132. It should also be noted that although the second titanium layer 30 is graphically depicted in substantially the same manner as titanium silicide sublayer 130, the two are chemically and electrically quite different.

Alternatively, noncrystalline silicon layer 32 may be selectively doped both p-type and n-type. For example the left half of silicon layer 32 could be doped n-type and the right half p-type (or vice versa) so that the silicide sublayer, once formed, would electrically connect integral, oppositely-doped portions of noncrystalline silicon layer 132.

Still referring to Fig. 2E, an insulating layer 34 is then formed and may be patterned as required on other portions of device 10. Then a layer of semiconductor material 36, preferably noncrystalline silicon, is formed and patterned as shown. Once again, silicon layer 36 may be selectively doped according to the application, as is well understood in the art.

Referring to Fig. 2F, overlying insulator 38 is then formed over the resulting structure to complete microelectronic device 10. It should be noted that other aspects of device have not been shown which would require other steps well understood in the art such as formation of bonding pads, etc.

Referring now to Fig. 3, comparison of Fig. 3 to Fig. 2F will help to reveal the portion of the SRAM cell structure depicted in Fig. 2F.

By reference to Fig. 3, moat 16 is the drain region of transistor TN3 and gate 14 is the gate region of transistor TN2. Strap 24 connects moat 16 to gate 14 and overlies but does not connect to gate region 20 of transistor TN3. Comparison of Figs. 3 and 2F also illustrates the structure of load transistor 40 (TP1) and load transistor 42 (TP2).

The benefits of the present invention will now be discussed. In the prior art, if silicide-reacting metal is to be used simultaneously for silicidation of straps and moats (e. g. metal layer 328 of Fig. 1B is used simultaneously for silicidation for strap 324 and moat 316 of Fig. 1C), the initial thickness of the metal layer is constrained by the sheet-resistivity requirements of the moat. For example about 1000 angstroms of titanium might be required.

On the other hand, according to the present invention, only the titanium layer deposited for purposes of forming titanium silicide layer 28 is constrained by sheet-resistivity requirements for the formation of silicide layer 28 in the formation of moat 16 while titanium layer 30 has no such thickness constraints. In other words, titanium layer 30 may be formed much thinner, e.g. in a range of about 100-300 angstroms is acceptable in some applications.

With reference to Fig. 2F, because of insulating layer 22, strap 24 can be connected to another conductive site e.g. to the right of unrelated gate 20. In the prior art, no such connection to another conductive site would be possible due to shorting problems associated with unrelated gates, as discussed above. Furthermore, insulating layer 22 also has high etch selectivity relative to titanium (as well as other metals and silicon) and thus etching constraints are considerably eased according to the invention.

Although the invention has been described in detail herein with reference to its preferred embodiments and certain described alternatives, it is to be understood that this description is by way of example only, and is not to be construed in a limiting sense. It is to be further understood that numerous details of the embodiments of the invention, and additional embodiments of the invention will be apparent to, and may be made by persons of ordinary skill in the art having reference to this description. It is contemplated that all such changes and additional embodiments are within the spirit and true scope of the invention as claimed below.

## Claims

1.  A method of forming a microelectronic device, said device incorporating low-resistivity straps between regions, the method comprising:

    (a) providing a substrate having a first region and a second region;

    (b) forming an insulating layer over said substrate;

    (c) removing selected portions of said insulating layer so as to at least partially expose both of said first and second regions;

    (d) forming a thin layer of a conductive, substrate-reactive material over said insulating layer and over said substrate so that said substrate-reactive material makes contact with said first and second regions;

    (e) forming a layer of semiconductor material over said layer of substrate-reactive material;

    (f) etching said layer of semiconductor material and said layer of substrate-reactive material so as to define a conducting strap between said first and second regions; and

    (g) reacting said layer of substrate-reactive material with said layer of semiconductor material and said first and second regions to form a reacted sublayer of said strap, whereby said reacted sublayer lowers contact resistance between said conducting strap and said first and second regions, and lowers the sheet resistance of said conducting strap between said first and second regions.

2.  The method of Claim 1 wherein step (g) is performed chronologically after step (f).

3.  The method of Claim 1 wherein said substrate substantially comprises monocrystalline silicon.

4.  The method of Claim 1 wherein said insulating layer substantially comprises oxide.

5.  The method of Claim 1 wherein said substrate-reactive material substantially comprises titanium.

6.  The method of Claim 1 wherein said layer of semiconductor material substantially comprises noncrystalline silicon.

7.  The method of Claim 1 wherein said layer of substrate-reactive material is formed to a thickness in a range of about 100-300 angstroms.

8.  The method of Claim 1 wherein said layer of semiconductor material is formed to a thickness in a range of about 500-2,500 angstroms.

9.  A microelectronic device, said device incorporating low-resistivity straps between regions, comprising:

    a substrate having a first region and a second region;

    an insulating layer selectively formed over said substrate said insulating layer not covering at least predetermined portions of said first and second regions;

    a conducting strap formed so as to make contact with said first and second regions, said conducting strap including a reacted sublayer, whereby said reacted sublayer lowers contact resistance between said conducting strap and said first and second regions, and lowers the sheet resistance of said conducting strap between said first and second regions.

10. The microelectronic device of Claim 9 wherein said first and second regions substantially include titanium silicide.

11. The microelectronic device of Claim 9 wherein said substrate substantially comprises monocrystalline silicon.

12. The microelectronic device of Claim 9 wherein said insulating layer substantially comprises oxide.

13. The microelectronic device of Claim 9 wherein said reacted sublayer substantially comprises titanium silicide.

*310*

*332*

*328*

*327*

*314*

*316*

*320*

*327*

*326*

*326*

*318*

*312*

PRIOR ART

*Fig. la*

*310*

*332*

*328*

*327*

*314*

*316*

*320*

*327*

*318*

*326*

*312*

*326*

*Fig. lb*

7

432
428
324
310
327
314
316
428
320
327
428
428
318
312
326

*Fig.1c*

432   428   324
310
327
314
338
428
428
318
312
316
326
320
428

*Fig.1d*

Fig.2a

Fig.2b

Fig.2c

Fig. 2d

Fig. 2e

*10*

*40*  *42*

*24*  *38*  *36*  *132*

*34*  *28*  *28*  *130*

*28*  *14*  *34*

*22*  *22*

*16*  *18*  *44*  *28*  *16*

*12*  *16*  *20*  *46*

**Fig. 2f**

V_DD

*40*  *42*

TP1  *24*  TP2  WL

WL  *16*  TN4

TN1  BL̄

BL  *14*

TN2  TN3

*20*

**Fig. 3**